# EUROPEAN PATENT APPLICATION

(11) **EP 3 780 384 A1**
(43) Date of publication of application: **17.02.2021**
(21) Application number: 18915673.0
(22) Date of filing: 16.04.2018
(51) Int. Cl.: H02S 40/22

(54) **SOLAR CONCENTRATOR**

(71) Applicant: Bolymedia Holdings Co., Ltd., Santa Clara, CA 95051 (US)
(72) Inventor: HU, Xiaoping, Shenzhen, Guangdong 518109 (CN)
(74) Representative: Manitz Finsterwald Patent- und Rechtsanwaltspartnerschaft mbB
(86) International application number: PCT/CN2018/083166
(87) International publication number: WO 2019/200503

(57) **Abstract**

Provided is a light-concentrating solar apparatus, comprising a light concentrating trough (110) and a double-sided light receiving device (120), wherein the light concentrating trough is provided with two walls (111, 111') extending along a ridge thereof, and the inner surfaces of the two walls are reflective surfaces. The double-sided light receiving device in a plate-like shape as a whole has both front and back surfaces thereof receiving sunlight (LL), the ridge (RD) thereof along the light concentrating trough being arranged between the two walls, and the front and back surfaces thereof respectively facing the inner surfaces of the two walls. Low cost reflective light concentrating is achieved by vertically sandwiching the double-sided light receiving device in the light concentrating trough. The apparatus can be fixedly mounted to lie along the ridge and can be vertically mounted as well as being adapted to requirements in regions at different latitudes.

## Description

### Technical Field

The present disclosure relates to clean energy, in particular to light-concentrating solar apparatus.

### Background

Solar energy systems have been widely used with the increasing demand for clean energy.

There have been two types of existing solar energy systems, including fixed-type ones and sun-tracking ones. For a fixed-type solar energy system, since it is generally installed on a fixed support and cannot be adjusted according to the deflection of the sun, its power generation is relatively low with short daily power generation time. A sun-tracking solar energy system is mounted on a sun-tracking device to generate more power, but it requires a large initial investment, a high maintenance cost and a sufficient installation site.

Therefore, it is necessary to study a solar energy system that is cost-effective, fixedly-installed and adaptive to the deflection of the sun.

### Summary of the Invention

According to the present disclosure, a light-concentrating solar apparatus is provided, which includes a light concentrating trough and a double-sided light receiving device. The light concentrating trough has two walls extending along a ridge thereof. One side of the two walls is open to form an opening of the light concentrating trough, and the other side is closed or has a gap to form as the ridge. The transverse dimension of the opening being greater than the transverse dimension of the ridge, and the inner surfaces of the two walls are reflective surfaces. The double-sided light receiving device has a plate shape as a whole, and its front and back surfaces can receive sunlight. It is arranged between the two walls along the ridge of the light concentrating trough, and its front and back sides face the inner surfaces of the two walls respectively. The double-sided light receiving device includes a double-sided photosensitive light-energy utilization device, or at least two single-sided photosensitive light-energy utilization devices facing opposite directions. Preferably, the double-sided light receiving device itself can also be a concentrating light-energy utilization device.

Preferably, there can be multiple sets of the above-mentioned light concentrating trough and double-sided light receiving device, and they can be arranged overlapping, that is, starting from the second set, the light concentrating trough in each subsequent set is arranged to have its opening facing the ridge of the light concentrating trough in the previous set. The outer surfaces of the two walls of the light concentrating trough in a former set are preferably reflective surfaces, and the transverse dimension of the opening of the light concentrating trough in a latter set is preferably larger than the transverse dimension of the opening of the light concentrating trough in the former set.

With the light-concentrating solar apparatus of the present disclosure, the double-sided light receiving device is vertically sandwiched between the light concentrating trough, so that low-cost reflective concentrating can be realized and, due to its adaptation to the deflection of the sun within a certain range, the power generation time of the apparatus can be extended. The apparatus can either be fixedly installed lying flat (along the ridge) or fixedly installed upright so as to meet the installation needs of different latitudes. Preferably, multiple sets of light concentrating troughs (and double-sided light receiving devices) can also be arranged in an overlapping manner to double the sunlight collection and conversion capabilities.

Specific examples according to the present disclosure are described in detail below with reference to the accompanying drawings. As used herein, the serial numbers or sequence numbers used herein, such as "first", "second", etc., are merely illustrative without any restrictive meanings. Terms that indicate a position, such as "upper", "lower", "front", "rear", "side", "top", "bottom" and the like, only refer to relative positional relationships, having no absolute meanings.

### Brief Description of the Drawings

FIG. 1 is a schematic diagram of a light-concentrating solar apparatus according to Embodiment 1;
FIG. 2 is a schematic diagram of a double-sided concentrating light-energy utilization device according to the present disclosure;
FIG. 3 is a schematic diagram of another double-sided concentrating light-energy utilization device according to the present disclosure;
FIG. 4 is a schematic diagram of still another double-sided concentrating light-energy utilization device according to the present disclosure;
FIG. 5 is a schematic diagram of a light-concentrating solar apparatus according to Embodiment 2;
FIG. 6 is a schematic diagram of a light-concentrating solar apparatus according to Embodiment 3;
FIG. 7 is a schematic diagram of light-concentrating solar apparatus according to Embodiment 4.

### Detailed Description

### Embodiment 1

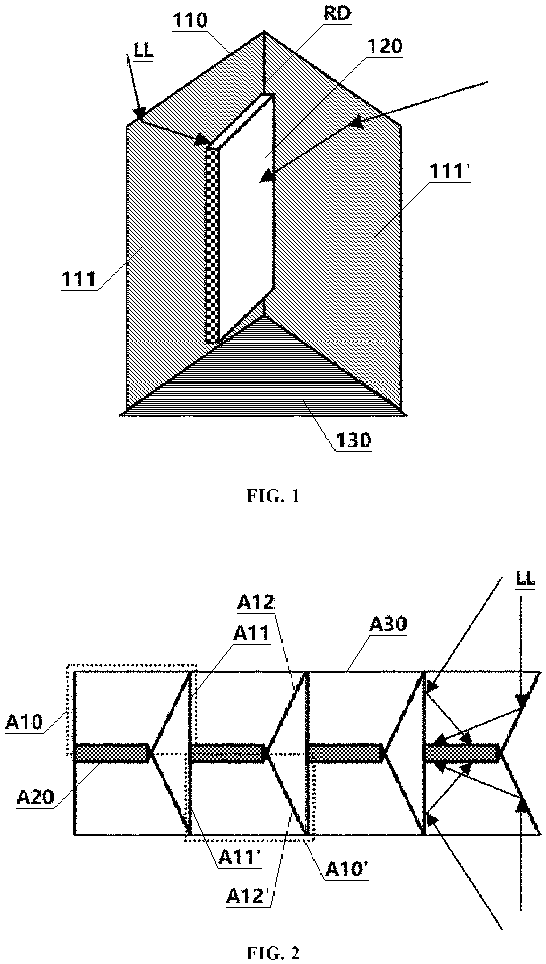

Referring to FIG. 1, a light-concentrating solar apparatus according to one embodiment of the present disclosure may include a light concentrating trough 110 and a double-sided light receiving device 120. LL shown in the figure and the following figures represents sunlight whose light path is indicated by arrows.

The light concentrating trough 110 is provided with two walls 111, 111' extending along a ridge RD thereof. One side of the two walls is open to form an opening of the light concentrating trough 110, and the other side of the two walls is closed to form the ridge RD. In other embodiments, the other side opposite to the opening side may not be closed but may have a certain gap for facilitating the drainage of water or dust. In this respect, the gap is the so-called ridge. The transverse dimension of the opening of the light concentrating trough is greater than the transverse dimension of the ridge, so as to facilitate the collection and convergence of light. The inner surfaces of the two walls, i.e. the surfaces of the two walls faced toward each other, are reflective ones. The reflective surfaces of the inner surfaces of the light concentrating trough in this embodiment may be flat; however, in other embodiments, they may also be bent or curved so that the inner surfaces of the light concentrating trough is formed into for example a substantially "V" or "U" shape.

The double-sided light receiving device 120 in a plate-like shape as a whole can receive sunlight at both front and back surfaces thereof. The double-sided light receiving device 120 is arranged between the two walls along the ridge RD of the light concentrating trough (for example at the central position between the walls) with the front and back surfaces thereof facing the inner surfaces of the two walls respectively. The double-sided light receiving device in this embodiment may be a double-sided photosensitive light-energy utilization device (such as a double-sided photovoltaic panel); however, in other embodiments, it may be two single-sided photosensitive light-energy utilization devices facing opposite directions (such as two single-sided photovoltaic panels arranged back to back). The photovoltaic panel herein may generally refer to any device that directly converts light energy into electrical energy, including various semiconductor photovoltaic panels, photovoltaic films, quantum-dot photoelectric conversion devices, etc.

An end reflective panel 130 which is arranged at an end of the light concentrating trough 110 and has a surface facing the inside of the light concentrating trough as a reflective surface is further included in this embodiment as a preferred embodiment to help improve the collection efficiency of the sunlight without significantly increasing cost.

The apparatus may adopt installation in a vertical manner along the ridge in the present embodiment, or it may adopt installation in a lying flat or reclining manner along the ridge in other embodiments. Regardless of the installation method, the above-mentioned light concentrating trough and the double-sided light receiving device can be combined and arranged with multiple sets thereof in an overlapping manner, in which the opening of a light concentrating trough in each subsequent set is arranged to face the ridge of a light concentrating trough in a previous set. For example, the sets of the combination can be arranged in a front-and-rear overlapped manner in the case of vertical installation, or the sets of the combination can be arranged in an up-and-down overlapped manner in the case of lying-flat installation.

The double-sided light receiving device only includes photovoltaic panels in this embodiment, but it can also include other types of light-energy utilization device such as a photothermal utilization device, or a combination of a photovoltaic panel and a photothermal utilization device. The double-sided light receiving device may also be a combination of a light-energy utilization device and a light guiding device, which can be called a double-sided "concentrating light-energy utilization device". The light guiding device can be selected from, for example, a conical tube and a bar-type groove, in which the conical tube has a reflective surface as its inner surface and a top opening larger than the one at the bottom, and a corresponding light-energy utilization device is arranged at the bottom of the conical tube. The bar-type groove provided with reflective surfaces as walls on both sides has a width at the top greater than that at the bottom, and a corresponding light-energy utilization device is arranged at the bottom of the light concentrating trough. These light guiding devices formed by the reflective surfaces can increase the concentration ratio of the apparatus at a lower cost.

In a preferred embodiment, the concentrating light-energy utilization device may include a plurality of units which are closely arranged to form a row structure, a column structure or an array structure. Each unit includes a light-energy utilization device and a conical tube or a light concentrating trough. Such structure miniaturizes a single unit, which is beneficial to maintain the optical parameters (e.g. the angle of the reflective surface of the light guiding device) and reduce the height of the light receiving device.

Referring to FIG. 2, a longitudinal section of a preferred double-sided concentrating light-energy utilization device is schematically shown. The shown device adopts a structure in which a plurality of units are integrated, including multiple front units A10 with openings on the front side and multiple back units A10' with openings on the back side. Each unit includes a bar-type groove and a photovoltaic panel arranged at the bottom of the groove. The walls A11, A11' and A12, A12' of the bar-type groove are reflective surfaces. The multiple front units A10 are arranged in one layer, and the multiple back units A10' are arranged in another layer. The arrangement of the two layers is identical and mirror-symmetrical. Therefore, each pair of symmetrically arranged front and back units can use the same double-sided photosensitive device A20. Alternatively, each pair of symmetrically arranged front and back units may also use single-sided photosensitive devices arranged back to back. The entire device can be packaged with a transparent cover A30 to facilitate cleaning.

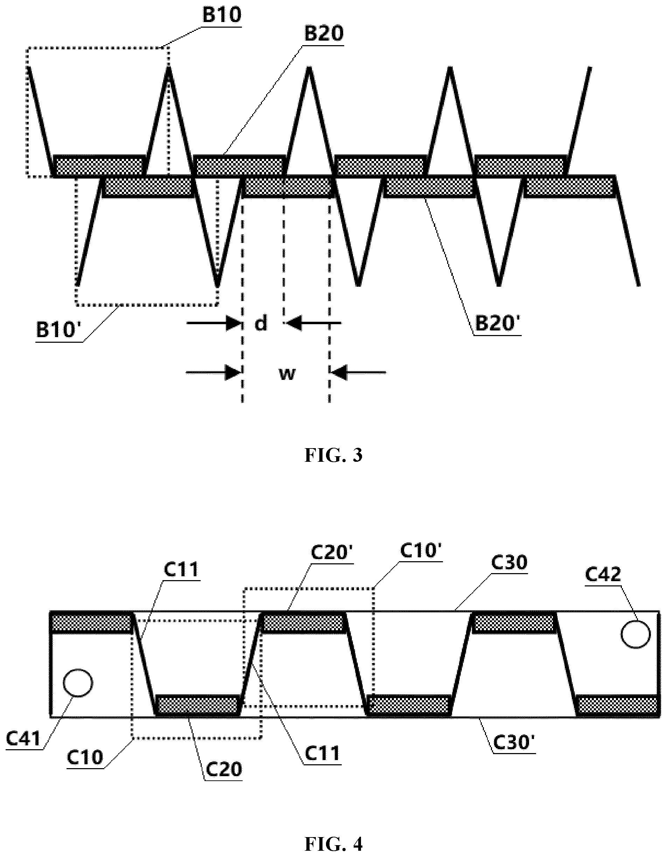

Referring to FIG. 3, a longitudinal section of another preferred double-sided concentrating light-energy utilization device is schematically shown. The structure of the shown device is similar to that of the device shown in FIG. 2, comprising multiple front units B10 and multiple back units B10'. The difference from FIG. 2 is that there is a predefined displacement distance d on the whole between the layer formed by the front unit B10 and the layer formed by the back unit B10' in general. In this respect, the front unit and back unit each employ a single-sided photosensitive device B20 or B20'. The displacement distance on the whole between the layers may preferably be half of the width w of the photosensitive device.

Referring to FIG. 4, a longitudinal section of still another preferred double-sided concentrating light-energy utilization device is schematically shown. The device includes a plurality of front units C10 and a plurality of back units C10'. Unlike the devices shown in FIGS. 2-3, the units C10 and the units C10' are alternately arranged on the same layer, forming a wave-shaped groove structure. Therefore, C10 and C10' share the wall C11, and both surfaces of the wall C11 are reflective surfaces. The photosensitive devices C20, C20' respectively arranged at the bottoms of C10, C10' can be single-sided photosensitive devices, but preferably double-sided photosensitive devices are used to fully utilize solar energy.

The entire device of FIG. 4 can be packaged with an ambient cover in a preferred structure, including a transparent top cover C30, a transparent bottom cover C30', and side covers (not shown). In a formed closed structure, a working fluid can be provided for heat dissipation or thermal energy utilization. Pipes C41, C42 connected to an external system can be provided on the end cover to facilitate heat exchange.

Further preferably, the light-concentrating solar apparatus according to the present disclosure can employ an ambient cover to form a closed cavity as a whole, and each reflective surface and each light receiving device are arranged in the cavity to facilitate cleaning of dust and protect internal devices. At least a part of the peripheral ambient covers is transparent, and these transparent ambient covers are arranged on the light path where sunlight enters the light-energy utilization device.

### Embodiment 2

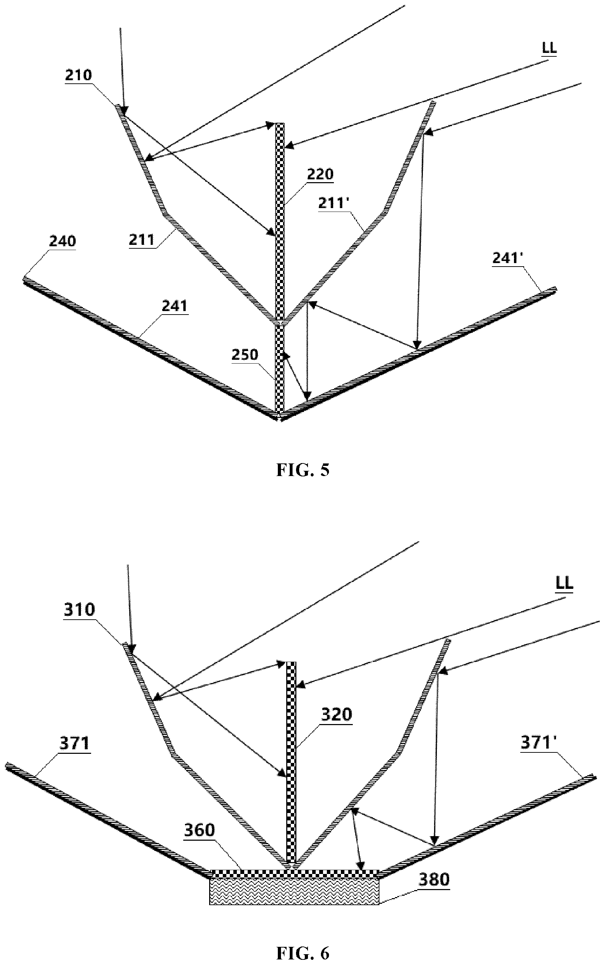

Referring to FIG. 5, a light-concentrating solar apparatus according to another embodiment of the present disclosure may include two sets of light concentrating troughs and double-sided light receiving devices.

The inner and outer surfaces of the two walls 211, 211' of the light concentrating trough 210 in the first set are both reflective ones formed as folded surfaces. The reflective surface of the outer surface helps to condense light for the subsequent light concentrating trough.

The inner surfaces of the two walls 241, 241' of the light concentrating trough 240 in the second set are reflective ones formed as flat surfaces. The outer surface need not be a reflective one. The light concentrating trough 240 is arranged to make its opening facing the ridge of the light concentrating trough 210 in the previous set, and the transverse dimension of the opening of the light concentrating trough 240 is larger than the transverse dimension of the opening of the light concentrating trough 210.

The double-sided light receiving device 220 in the first set and the double-sided light receiving device 250 in the second set are respectively erected at the center of the light concentrating troughs 210, 240. Specifically, double-sided photovoltaic panels or double-sided concentrating light-energy utilization device as described above can be used.

In other embodiments, more sets of light concentrating troughs and double-sided light receiving devices can be adopted to collect and convert more solar energy.

### Embodiment 3

Referring to FIG. 6, a light-concentrating solar apparatus according to still another embodiment of the present disclosure may include light concentrating trough 310 and double-sided light receiving device 320 which are similar to the light concentrating trough 210 and the double-sided light receiving device 220 and will not be repeated here.

A single-sided light receiving device 360 and inclined reflective panels 371, 371' arranged on both side of the single-sided light receiving device are further included in this embodiment. These reflective panels can help to condense the sunlight outside the concentrating trough onto the single-sided light receiving device 360. The single-sided light receiving device 360 shaped as plate-like overall has a light receiving surface facing the ridge of the light concentrating trough 310 and arranged outside the light concentrating trough 310. The single-sided light receiving device 360 may include a single-sided photosensitive light-energy utilization device, such as a single-sided photovoltaic panel, or may also be a combination of a single-sided photosensitive light-energy utilization device and a light guiding device, such as one layer of the double-sided concentrating light-energy utilization device shown in FIG. 2 or FIG. 3.

The apparatus of this embodiment can also be regarded as two overlapping light concentrating troughs, in which the light receiving device arranged in the last light concentrating trough is lying flat instead of upright, and is a single-sided light receiving device.

In other embodiments, when a light concentrating trough is continued to be stacked downward, the single-sided light receiving device 360 is needed to be replaced with a double-sided light receiving device and the back surfaces of the reflective panels 371, 371' are also configured as reflective ones.

A water heater 380 is further included in this embodiment as a preferred embodiment. The water heater 380 is also arranged under the back side of the light receiving surface of the single-sided light receiving device 360, and is thermally connected with the single-sided light receiving device 360 and the double-sided light receiving device 320. Its function is to cool the single-sided light receiving device 360 and the double-sided light receiving device 320, and to provide hot water at the same time. In this respect, a metal plate (not shown) can be provided inside the double-sided light receiving device, which can be inserted into the water heater 380 to achieve rapid heat conduction.

### Embodiment 4

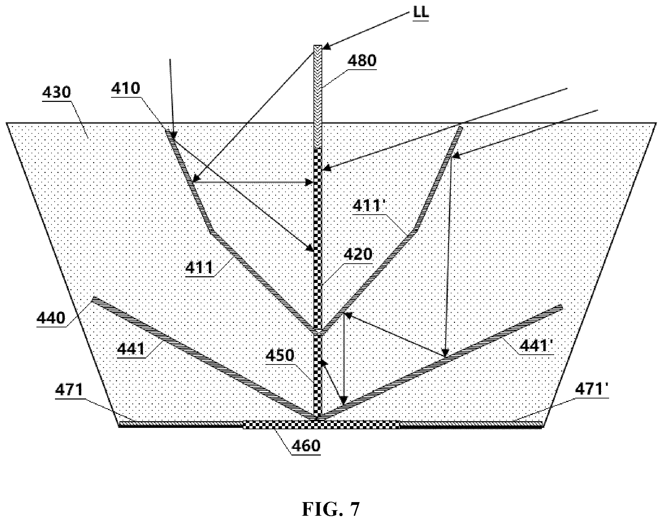

Referring to FIG. 7, a light-concentrating solar apparatus according to still yet another embodiment of the present disclosure may include two sets of light concentrating troughs and double-sided light receiving devices, i.e. light concentrating troughs 410, 440 and double-sided light receiving devices 420, 450. There are similarities between they and the light concentrating troughs 210, 240 and the double-sided light receiving device 220, 250 (which will not be repeated here), and the difference therebetween is that the outer surfaces of the two walls 441, 441' of the light concentrating trough 440 are also reflective surfaces.

A single-sided light receiving device 460 and reflective panels 471, 471' arranged on both sides thereof are also included in this embodiment. They are similar to the single-sided light receiving device 360 and the reflective panels 371, 371' in the Embodiment 3, except that the reflective panels 471, 471' are lying flat due to the requirement of a larger opening.

A Fresnel lens 480 arranged on the optical path of the sunlight before it is incident on the reflective surface of the light concentrating trough 410 (for example, erected between the two walls 411, 411' of the light concentrating trough 410 and in front of its optical path) is further included in this embodiment as a preferred embodiment. The Fresnel lens 480 selected from a linear Fresnel lens and a partial Fresnel lens can be used to deflect the sunlight downward to help to increase the concentration ratio of the light concentrating trough 410. The so-called "linear Fresnel lens" means that the focal center of the lens is not a point but a line. The so-called "partial Fresnel lens" means that the tooth surface of the Fresnel lens is not a complete symmetrical pattern but only a part of it; for example, a partial Fresnel lens is formed by cutting a complete circular Fresnel lens at a position close to the diameter thereof.

An end reflective panel 430 to improve the overall performance of the apparatus is also included in this embodiment as a preferred embodiment. With the apparatus of this embodiment, a large amount of power generation in a unit space can be achieved, making it possible to extend the daily power generation time with a high light energy utilization efficiency thereof.

The apparatus of this embodiment can also be regarded as three overlapped light concentrating troughs, in which the last arranged light concentrating trough has been opened as a plate-like shape, and the light receiving device thereof is a flat single-sided light receiving device.

The principle and implementation manners of the present disclosure has been described above with reference to specific embodiments, which are merely provided for the purpose of understanding the present disclosure and should not be construed as limiting the present disclosure. It will be possible for those skilled in the art to make variations based on the idea of the present disclosure.

## Claims

1. A light-concentrating solar apparatus, comprising:
a light concentrating trough having two walls extending along a ridge thereof, one side of the two walls being opened to form an opening of the light concentrating trough, and the other side being closed or having a gap to form as the ridge, a transverse dimension of the opening being greater than a transverse dimension of the ridge, and inner surfaces of the two walls being reflective surfaces; and
a double-sided light receiving device in a plate-like shape as a whole having front and back surfaces capable of receiving sunlight, the double-sided light receiving device being arranged between the two walls along the ridge of the light concentrating trough, with its front and back surfaces respectively facing the inner surfaces of the two walls, and the double-sided light receiving device including a double-sided photosensitive light-energy utilization device, or at least two single-sided photosensitive light-energy utilization devices facing opposite directions.

2. The solar apparatus according to claim 1, wherein:
the reflective surface is a flat one or a folded one or a curved one.

3. The solar apparatus according to claim 1 or 2, further comprising:
a Fresnel lens arranged on an optical path of sunlight before it is incident on the reflective surface, and the Fresnel lens being selected from a linear Fresnel lens and a partial Fresnel lens.

4. The solar apparatus according to any one of claims 1 to 3, wherein:
there are at least two sets of light concentrating troughs and double-sided light receiving devices,
outer surfaces of two walls of a light concentrating trough in a first set are reflective, and
a light concentrating trough in a second set is arranged so that its opening faces a ridge of a light concentrating trough in the first set.

5. The solar apparatus according to claim 4, wherein:
a transverse dimension of an opening of a light concentrating trough in the second set is larger than a transverse dimension of an opening of a light concentrating trough in the first set.

6. The solar apparatus according to any one of claims 1 to 5, further comprising:
a single-sided light receiving device in a plate-like shape as a whole having a light receiving surface which faces the ridge of the light concentrating trough and is arranged on an outside of the light concentrating trough, the single-sided light receiving device including a single-sided photosensitive light-energy utilization device, or a combination of a single-sided photosensitive light-energy utilization device and a light guiding device.

7. The solar apparatus according to claim 6, further comprising:
a water heater arranged on a back side of a light receiving surface of the single-sided light receiving device and thermally connected to the single-sided light receiving device and the double-sided light receiving device.

8. The solar apparatus according to any one of claims 1 to 7, further comprising:
at least one end reflective panel arranged at an end of the light concentrating trough and having a reflective surface as its surface facing an inside of the light concentrating trough.

9. The solar apparatus according to any one of claims 1 to 8, further comprising:
ambient covers for forming the solar apparatus into a closed cavity, wherein each reflective surface and each light receiving device are arranged in the cavity, and
at least part of the ambient covers is transparent and arranged on an optical path where sunlight is incident onto the light-energy utilization device.

10. The solar apparatus according to any one of claims 1 to 9, wherein:
the double-sided light receiving device further includes at least one light guiding device which is selected from a conical tube and a bar-type groove,
a top opening of the conical tube is larger and a bottom opening thereof is smaller, an inner surface of the conical tube is a reflective surface, and a corresponding light-energy utilization device is arranged at the bottom of the conical tube,
width of a top of the bar-type groove is greater than width of a bottom thereof, walls on both sides thereof are reflective surfaces, and a corresponding light-energy utilization device is arranged at the bottom of the bar-type groove.

11. The solar apparatus according to claim 10, wherein:
the double-sided light receiving device includes a plurality of units that are closely arranged to form a row structure, a column structure or an array structure, and each unit respectively includes a light-energy utilization device and a conical tube or a bar-type groove.

12. The solar apparatus according to claim 11, wherein:
the plurality of units includes multiple front units with openings on a front side and multiple back units with openings on a back side,
the multiple front units are arranged in one layer, the multiple back units are arranged in another layer, and arrangements of the two layers are identical and mirror-symmetrical, or
the multiple front units are arranged in one layer, and the multiple back units are arranged in another layer, and arrangement of the two layers are identical and there is a predefined displacement distance between the two layers, or
the multiple front units are arranged in one layer, and the multiple back units are alternately arranged on the same layer.
